(19) Europäisches Patentamt
European Patent Office
Office européen des brevets

(11) Publication number: 0 026 967 B1

(12) EUROPEAN PATENT SPECIFICATION

(45) Date of publication of patent specification: 15.10.86

(51) Int. Cl.[4]: H 01 L 21/312, H 01 L 21/60, H 01 L 21/90

(21) Application number: 80302569.1

(22) Date of filing: 28.07.80

# (54) A method of manufacturing a semiconductor device using a thermosetting resin film.

(30) Priority: 31.07.79 JP 97656/79

(43) Date of publication of application: 15.04.81 Bulletin 81/15

(45) Publication of the grant of the patent: 15.10.86 Bulletin 86/42

(84) Designated Contracting States: DE FR GB

(56) References cited:
DE-A-2 638 799
FR-A-2 258 002
US-A-3 700 497
US-A-3 801 880

JOURNAL OF THE ELECTROCHEMICAL SOCIETY, vol. 124, no. 10, October 1977, pages 1619-1622, Princeton (USA); A. SAIKI et al.: "A new transistor with two-level metal electrodes".

(73) Proprietor: FUJITSU LIMITED
1015, Kamikodanaka Nakahara-ku
Kawasaki-shi Kanagawa 211 (JP)

(72) Inventor: Kurahashi, Toshio
925-A-403, Mamedo-cho Kohoku-ku
Yokohama-shi Kanagawa 222 (JP)
Inventor: Tokitomo, Kazuo
260-12, Kitatakizawa Hachiman Itsukimachi
Aizuwakamatsu-shi Fukushima 965 (JP)
Inventor: Ono, Toshihiko
2845-7, Arima Takatsu-ku
Kawasaki-shi Kanagawa 213 (JP)

(74) Representative: Overbury, Richard Douglas et al
HASELTINE LAKE & CO Hazlitt House
28 Southampton Buildings Chancery Lane
London WC2A 1AT (GB)

EP 0 026 967 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to methods of manufacturing semiconductor devices.

In recent years, resin in the interrelated group of polyimide (such resin to be called hereinafter polyimide resin) has been noticed because of its heat resisting nature and utilized in various ways in the manufacture of semiconductor devices. The latest trend is to use polyimide resin even as a covering and protecting film. Its purpose is to protect the surface of a semiconductor device against scratches or damage during or after manufacture thereof. In addition, it has become known that polyimide resin also has the effect of preventing "soft errors" of a semiconductor chip.

The term "soft errors" is applied to the extremely vexatious problems which can arise when α-rays are radiated by a radioactive substance contained in the material of an encapsulating package in which a semiconductor chip is contained. The radioactive substance may be present only in quantities of the order of PPM (parts per million), but such α-rays can destroy memory data.

However, polyimide resin has poor performance in terms of adhesiveness, more so in regard to a film of oxidized silicon, so that it has a weakness in that its sealing effect may not be sufficient. Because of this, according to current practice, polyimide resin is coated thinly, so that the thickness of a film of the resin is approximately 1 µm, then heat treated and hardened until the film adheres closely. Thereafter, polyimide resin is applied again to a film thickness of approximately 20 µm for example, then heat treated and hardened. In spite of this, however, adhesiveness can still not be regarded as satisfactory.

FR—A—2 258 002 discloses the use of a layer of at least one photo-laquer which has been hardened by heat treatment as a protective layer for a semiconductor device.

According to the present invention there is provided a method of manufacturing a semiconductor device comprising a semiconductor substrate, characterised by the steps of:—

covering a surface with a photoresist film,

carrying out a heat treatment to harden the photoresist film,

covering the hardened photoresist film with a thermosetting resin film, the thermosetting resin comprising a polyimide resin, or a polyamide resin, or a polyester resin or an organo-polysiloxane resin, or an organo siloxane resin, and

carrying out a further heat treatment to cure the thermosetting resin film.

Embodiments of the invention can provide for the elimination of defects experienced in the conventional art and can offer a method of manufacture which improves adhesiveness of a surface protection film consisting of the above-mentioned thermosetting resins, for example, polyimide resin. Briefly, in an embodiment of this invention, the following steps are taken:— photoresist is applied to cover the surface of a semiconductor chip in advance to be heat treated, then a thermosetting resin, for example polyimide resin is applied to cover the upper surface of the film of photoresist, and heat treatment is carried out thereafter.

The resin can then serve to cover and protect the chip.

Reference will be made, by way of example, to the accompanying drawings, in which:—

Figures 1 to 6 are respective cross-sectional views illustrating successive steps effected when carrying out a method embodying the present invention.

Figure 1 shows a step wherein a wiring conductor layer 2 of aluminium is formed in accordance with desired circuit pattern on a semiconductor substrate 1, with an insulator layer 3 which typically consists of phospho-silicate glass (PSG) formed on the semi-conductor substrate surface and covering the upper surface of the layer 2 by chemical vapour deposition (CVD).

Next, as shown in Figure 2, a positive photoresist is applied by a spin coating technique using a conventional spinner to form a film 4 on the substrate over layer 3. The photoresist is then baked or heat treated at a temperature in the range from 100°C to 120°C to harden the film thereof. The photoresist film thickness varies depending upon the surface condition of the PSG layer, but thickness between 7000Å and 3 µm has been found to be appropriate. The photoresist film 4 is formed so as to cover the layers 2 and 3.

Well known positive photoresist compounds consisting of substituted o-naphthoquinone-diazides as photoactive compounds mixed with Novolak-type resins may be used in this embodiment. Such photoresist compounds are disclosed in detail in a technical paper entitled "Photochemical Decomposition Mechanism For AZ-Type Photoresists" by J. Pacansky et al at pages 42 to 55 of IBM Journal of Research and Development, Vol. 23, No. 1, January 1979. Negative photoresists also may be used as the material for forming the film 4 in the present invention. For this purpose, negative photoresist compounds known in the art such as cyclized polyisoprene having an average molecular weight of 60,000 to 70,000 before the coating process mixed with a cross-linking agent of 2—6—4 bisazidebenzal-methylcyclohexane may be used. This negative photoresist compound generally comes to have an average molecular weight of more than 100,000 after a baking process at 150°C for example which is carried out before an exposure process.

Then, as illustrated in Figure 3, the photoresist film 4 is exposed to ultraviolet light through a mask, and then patterned by a conventional development technique to make an opening at that part thereof on the PSG layer over aluminium layer 2, for a terminal pad. Such openings are formed at positions on the aluminium layer 2 where terminal pads for connecting lead wires or contact windows are to be formed or at positions

for connecting first and second aluminium wiring layers with each other. Thereafter, that part of the PSG layer exposed in the opening in the photoresist film 4, which functions as a mask, is removed by etching to make an opening 5 on the wiring layer 2. Then a heat treatment of the substrate at a high temperature of more than 300°C, 450°C for example is carried out in an inert ambience of nitrogen gas for more than 10 minutes. Through such process, the positive photoresist film 4 becomes thermally stable.

Thereafter, as shown in Figure 4, polyimide resin 6 is applied by a spin coating technique using a conventional spinner and then heat treated at a temperature of approximately 200°C to harden the polyimide resin film 6. The thickness of the film 6 of polyimide resin is made between 10 µm and 20 µm.

The polyimide resin used in this embodiment is well known in the art and has the basic molecular structure represented by the following chemical formula

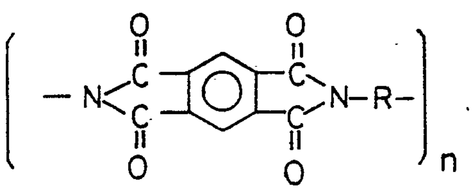

in which R represents alkylene radicals having 1 to 3 carbon atoms, diphenylether radicals, or phenylene radicals. As a solvent for such polyimide resins, to prepare a polyimide resin solution for a spin coating process, N methyl-2-pyrrolidone or N dimethyl acetamide may be used. Polyimide resins disclosed in Japanese patent publications, JA—B—48—2957 and 48—2958 are also preferable in the present invention.

Other thermosetting resins can be used, such as aromatic polyamides having the following basic molecular structure

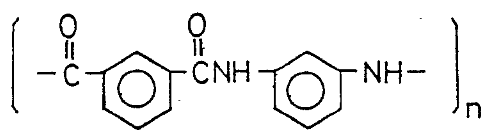

or aromatic polyesters having the following basic molecular structure

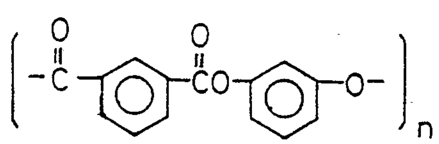

or ladder type organo-polysiloxane resins having the following molecular formula

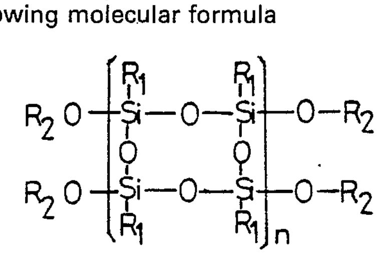

or poly simple organo siloxane resins having the following chemical formula

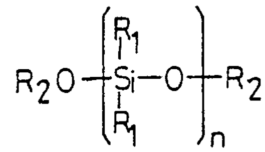

in which $R_1$ represents methyl or phenyl radicals and $R_2$ represents hydroxy or ethoxy radicals (or $R_2$ represents H or $C_2H_5$).

The next step is, as seen in Figure 5, to apply negative photoresist film 7 and to effect patterning thereof in order to partially remove polyimide resin 6 to make an opening 5 for a terminal pad or a contact window. With an opening patterned in the photoresist film 7 an etchant in liquid form is used for etching the polyimide resin to form an opening or a window.

Then, as illustrated in Figure 6, the negative photoresist film 7 is removed by a suitable organic solvent and a heat treatment is carried out again at a high temperature of 450°C in order to cure the polyimide resin thereby to realize stabilization of the polyimide resin 6 at high temperatures.

Alternatively, in another embodiment, where there is no PSG layer on the conductor layer of aluminium and thus the aluminium conductor layer is entirely exposed, it is possible to interpose positive photoresist film as an interlayer, apply polyimide resin thereon and carry out the heat treatment in the same manner as described above to make the resin a protective layer.

In the foregoing embodiments, heat treatment is effected on the polyimide resin at a temperature of 450°C, but this is done in view of the fact that a chip bonding operation involving a high temperature of about 450°C is to be performed subsequently anyway. Although it is not intended therefore to limit the heat treatment temperature to 450°C, a heat treatment at a temperature higher than 300°C to cure the thermosetting resin for the protective film should be done in any case.

As has been described, where a thermosetting resin film for providing a protective layer is formed, a photoresist film is formed thereunder, and thermal stability is attained by heat treatment at a high temperature. Therefore, a photoresist film having satisfactory adherence characteristics serves the purpose of improving adherence between a film of silicon dioxide, a PSG layer or a layer of metal such as aluminium on the surface of a semiconductor substrate and a polyimide resin film.

Further, in the manufacturing steps involved in producing a semiconductor device, a completed semiconductor chip is obtained by dicing the substrate and is placed in a suitable encapsulated package, and after wire bonding operations are complete, a thermosetting resin, more especially polyimide resin, may be used to cover the entire surface of the semiconductor chip, or a polyimide resin film may be interposed between multiple

conductor layers as an insulation layer. In either case, adherence characteristics can substantially be improved by utilizing a photoresist film.

Therefore, in embodiments of the present invention, it is possible to cause thermosetting resin film to adhere sufficiently well to a desired surface in order to protect the semiconductor device against surface scratches or soft errors for example. This has the effect of increasing the reliability of semiconductor devices.

Thus, in a method of manufacturing a semiconductor device embodying this invention, a layer of aluminium is patterned on a semiconductor substrate and a layer of phospho-silicate glass is formed over the aluminium and the exposed substrate surface, and then the exposed surface (of the layer of PSG) is covered with a positive photoresist film which is then heat treated. The exposed surface of the photoresist film is covered with a polyimide resin which is thereafter heat treated. Alternatively, where the semiconductor device is devoid of the layer of phospho-silicate glass and has the layer of aluminium conductor exposed, a film of positive photoresist is interposed, the polyimide resin is applied to cover the exposed surface of the interposed layer, and is then heat treated.

**Claims**

1. A method of manufacturing a semiconductor device comprising a semiconductor substrate, characterised by the steps of:—

covering a surface with a photoresist film,

carrying out a heat treatment to harden the photoresist film,

covering the hardened photoresist film with a thermosetting resin film, the thermosetting resin comprising a polyimide resin, or a polyamide resin, or a polyester resin or an organo-polysiloxane resin, or an organo siloxane resin, and

carrying out a further heat treatment to cure the thermosetting resin film.

2. A method of manufacturing a semiconductor device as claimed in claim 1, the device comprising the semiconductor substrate and a wiring layer of aluminium on the substrate, and the method comprising the steps of:—

forming the photoresist film on the substrate to cover the wiring layer,

carrying out the said heat treatment to harden the photoresist film,

forming the thermosetting resin film to cover the photoresist film,

partially removing the thermosetting resin film (and the photoresist film) to make an opening on the aluminium wiring layer,

carrying out said further heat treatment to cure the thermosetting resin film.

3. A method of manufacturing a semiconductor device as claimed in claim 1, the device comprising the semiconductor substrate and a wiring layer formed on the substrate, and the method comprising the steps of:—

forming an insulator layer on the substrate to cover the wiring layer,

forming the photoresist film on the substrate to cover the insulator layer,

carrying out the said heat treatment to harden the photoresist film,

forming a window in the photoresist film at a position over the wiring layer,

carrying out etching of the insulator layer (through the window formed in the photoresist film) to make an opening on the wiring layer,

forming the thermosetting resin film on the substrate to cover the photoresist film (and the opening for example),

partially removing the thermosetting resin film to make an opening (to remake the opening) on the wiring layer, and

carrying out the said further heat treatment to cure the thermosetting resin film.

4. A method as claimed in claim 3, wherein the insulator layer consists of phospho-silicate glass.

5. A method as claimed in any preceding claim, wherein the said further heat treatment is carried out at a temperature higher than 300°C.

6. A method as claimed in claim 5, wherein the said further heat treatment is carried out at a temperature of 450°C.

7. A method as claimed in any preceding claim, wherein the photoresist film consists of a positive photoresist compound.

8. A method as claimed in any preceding claim, wherein the cured thermosetting resin film is so formed as to serve as a protective film for the device.

**Revendications**

1. Procédé de fabrication d'un dispositif semiconducteur comprenant un substrat semiconducteur, caractérisé par les opérations suivantes:

couvrir une surface à l'aide d'une pellicule d'agent photosensible,

effectuer un traitement thermique pour faire durcir la pellicule d'agent photosensible,

couvrir la pellicule durcie d'agent photosensible au moyen d'une pellicule de résine thermodurcissable, la résine thermodurcissable comprenant une résine de polyimide, ou une résine de polyamide, ou une résine de polyester, ou une résine d'organo-polysiloxanne, ou une résine d'organo-siloxanne, et

effectuer un traitement thermique supplémentaire afin de faire durcir la pellicule de résine thermodurcissable.

2. Procédé de fabrication d'un dispositif semiconducteur selon la revendication 1, le dispositif comprenant le substrat semiconducteur et une couche de câblage en aluminium située sur le substrat, et le procédé comprenant les opérations suivantes:

former la pellicule d'agent photosensible sur le substrat afin de couvrir la couche de câblage,

effectuer ledit traitement thermique afin de faire durcir la pellicule d'agent photosensible,

former la pellicule de résine thermodurcissable afin de couvrir la pellicule d'agent photosensible,

retirer partiellement la pellicule de résine thermodurccissable (et la pellicule d'agent photosensible) pour pratiquer une ouverture sur la couche de câblage en aluminium,

effectuer ledit traitement thermique supplémentaire afin de faire durcir la pellicule de résine thermodurcissable.

3. Procédé de fabrication d'un dispositif semiconducteur selon la revendication 1, le dispositif comprenant le substrat semiconducteur et une couche de câblage formée sur le substrat, et le procédé comprenant les opérations suivantes:

former une couche d'isolant sur le substrat afin de couvrir la couche de câblage,

former la pellicule d'agent photosensible sur le substrat afin de couvrir la couche d'isolant,

effectuer ledit traitement thermique afin de faire durcir la pellicule d'agent photosensible,

former une fenêtre dans la pellicule d'agent photosensible en une position se trouvant audessus de la couche de câblage,

effectuer l'incision de la couche d'isolant (au travers de la fenêtre formée dans la pellicule d'agent photosensible) afin de pratiquer une ouverture sur la couche de câblage,

former la pellicule de résine thermodurcissable sur le substrat afin de couvrir la pellicule d'agent photosensible (et l'ouverture par example),

retirer partiellement la pellicule de résine thermodurcissable afin de pratiquer une ouverture (de pratiquer de nouveau l'ouverture) sur la couche de câblage, et

effectuer ledit traitement thermique supplémentaire afin de faire durcir la pellicule de résine thermodurcissable.

4. Procédé selon la revendication 3, où la couche d'isolant est constituée de verre au phospho-silicate.

5. Procédé selon l'une quelconque des revendications précédentes, où ledit traitement thermique supplémentaire est effectué à une température supérieure à 300°C.

6. Procédé selon la revendication 5, où ledit traitement thermique supplémentaire est effectué à une température de 450°C.

7. Procédé selon l'une quelconque des revendications précédentes, où la pellicule d'agent photosensible est constituée d'un composé d'agent photosensible positif.

8. Procédé selon l'une quelconque des revendications précédentes, où la pellicule durcie de résine thermodurcissable est formée de manière à servir de pellicule protectrice pour le dispositif.

**Patentansprüche**

1. Verfahren zur Herstellung einer Halbleitervorrichtung mit einem Halbleitersubstrat, gekennzeichnet durch die folgenden Schritte:—

Bedecken einer Oberfläche mit einem Fotoresistfilm,

Durchführung einer Wärmebehandlung zum Härten des Fotoresistfilms,

Bedecken des gehärteten Fotoresistfilms mit einem wärmehärtenden Harzfilm, welcher ein Polyimidharz umfaßt, oder ein Polyamidharz, oder ein Polyesterharz oder ein Organo-Polysiloxanharz oder ein Organo-Siloxanharz, und

Durchführung einer weiteren Wärmebehandlung zur Aushärtung des wärmehärtenden Harzes.

2. Verfahren zur Herstellung einer Halbleitervorrichtung nach Anspruch 1, welche das Halbleitersubstrat und eine Verdrahtungsschicht aus Aluminium auf dem Substrat enthält, und welches Verfahren die folgenden Schritte umfaßt:—

Bildung des Fotoresistfilms auf dem Substrat, um die Verdrahtungsschicht zu bedecken,

Durchführung der genannten Wärmebehandlung, um den Fotoresistfilm zu härten,

Bildung des wärmehärtenden Harzfilmes, um den Fotoresistfilm zu bedecken,

teilweise Entfernung des wärmehärtenden Harzfilmes (und des Fotoresistfilms), um eine Öffnung auf der Aluminiumverdrahtungsschicht zu bilden,

Durchführung der genannten weiteren Wärmebehandlung, um den wärmehärtenden Harzfilm auszuhärten.

3. Verfahren zur Herstellung einer Halbleitervorrichtung nach Anspruch 1, welche das Halbleitersubstrat und eine auf dem Substrat gebildete Verdrahtungsschicht umfaßt, und welches Verfahren die folgenden Schritte umfaßt:—

Bildung einer Isolatorschicht auf dem Substrat, um die Verdrahtungsschicht zu bedecken,

Bildung des Fotoresistfilms auf dem Substrat, um die Isolatorschicht zu bedecken,

Durchführung der genannten Wärmebehandlung, um den Fotoresistfilm zu härten,

Bildung eines Fensters in dem Fotoresistfilm an einer Position über der Verdrahtungsschicht,

Durchführung der Ätzung der Isolatorschicht (durch das in dem Fotoresistfilm gebildete Fenster), um eine Öffnung auf der Verdrahtungsschicht zu machen,

Bildung des wärmehärtenden Harzfilmes auf dem Substrat, um den Fotoresistfilm (und z. B. die Öffnung) zu bedecken,

teilweise Entfernung des wärmehärtenden Kunstharzfilmes auf der Verdrahtung, um eine Öffnung zu machen (die Öffnung wiederherzustellen), und

Durchführung der genannten weiteren Wärmebehandlung, um den wärmehärtenden Harzfilm auszuhärten.

4. Verfahren nach Anspruch 3, bei welchem die Isolatorschicht aus Phosphosilikatglas besteht.

5. Verfahren nach einem der vorgehenden Ansprüche, bei welchem die genannte weitere Wärmebehandlung bei einer Temperatur oberhalb 300°C durchgeführt wird.

6. Verfahren nach Anspruch 5, bei welchem die genannte weitere Wärmebehandlung bei einer Temperatur von 450°C durchgeführt wird.

7. Verfahren nach einem der vorhergehenden Ansprüche, bei welchem der Fotoresistfilm aus einer positiven Fotoresistverbindung besteht.

8. Verfahren nach einem der vorhergehenden Ansprüche, bei welchem der ausgehärtete wärmehärtende Harzfilm so geformt wird, daß er als Schutzfilm für die Vorrichtung dient.

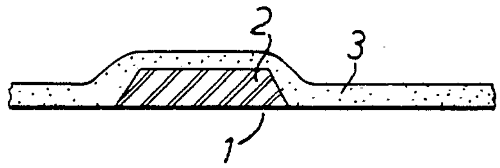

FIG. 1.

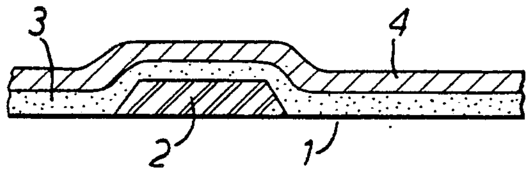

FIG. 2.

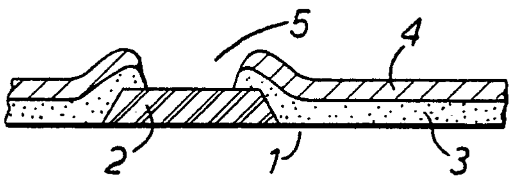

FIG. 3.

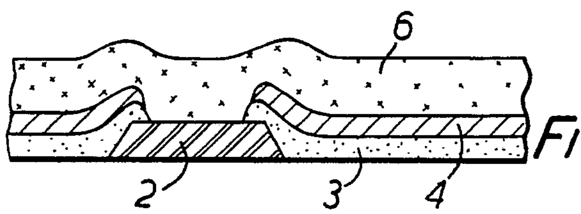

FIG. 4.

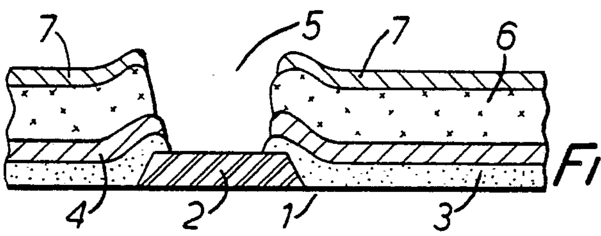

FIG. 5.

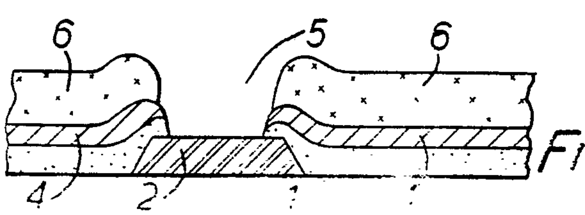

FIG. 6.